# EUROPÄISCHE PATENTANMELDUNG

(11) **EP 4 835 496 A1**
(43) Veröffentlichungstag der Anmeldung: **04.11.2026**
(21) Anmeldenummer: 26170557.8
(22) Anmeldetag: 02.04.2026
(51) Int. Cl.: G01R 15/20, G01R 1/22, G01R 15/18, G01R 1/04

(54) **ELEKTRONISCHES MESSGERÄT ZUR KONTAKTLOSEN ERFASSUNG ELEKTRISCHER GRÖSSEN**

(30) Priorität: 28.04.2025 DE 102025116134
(71) Anmelder: Robert Bosch GmbH, 70442 Stuttgart (DE)
(72) Erfinder: Chan, Chi Fung, 73760 Ostfildern (DE); Ying, Jianbang, Hangzhou, Zhejiang, 311400 (CN); Zhang, Xinhui, Hangzhou, 311400 (CN)

(57) **Zusammenfassung**

Die Erfindung bezieht sich auf ein elektronisches Messgerät (10), mit welchem elektrische Größen, insbesondere Spannung und/oder Strom kontaktlos gemessen werden. Das elektronische Messgerät (10) umfasst einen stationären Schenkel (12) und einen bewegbaren Schenkel (14). In diesen sind jeweils Magnetkerne (30, 32) aufgenommen. In einem der stationären oder bewegbaren Schenkel (12, 14) ist ein Hall-Sensor (34) platziert. In dem jeweils anderen Schenkel (12, 14) ist eine dem Hall-Sensor (34) gegenüberliegende Wandstärkenreduzierung (42) ausgebildet, die Abstände (64) zwischen den Stirnseiten (66, 68; 70, 72) der Magnetkerne (30, 32) reduziert.

## Beschreibung

### Technisches Gebiet

Die Erfindung bezieht sich auf ein elektronisches Messgerät zur kontaktlosen Erfassung von elektrischen Größen, insbesondere Strom und/oder Spannung, mit einem stationären Schenkel und einem um ein Gelenk bewegbaren Schenkel, in denen jeweils Magnetkerne aufgenommen sind, wobei in einem der stationären oder bewegbaren Schenkel ein Hall-Sensor aufgenommen ist.

### Stand der Technik

Bei elektrischen Messgeräten, welche kontaktlose Strommessungen gemäß dem Faraday'schen Gesetz vornehmen, werden in der Regel zwei etwa halbkreisförmig angeordnete Magnetkerne in entsprechenden Gehäusen aus nicht-leitendem Material aufgenommen. In der Regel umfassen derartige Geräte einen stationären und einen beweglichen Schenkel, wobei der bewegliche Schenkel beispielsweise um ein Gelenk relativ zum stationären Schenkel beweglich ist. Innerhalb der beiden Schenkel sind die etwa halbkreisförmig ausgebildeten Magnetkerne angeordnet. Des Weiteren ist in einem der beiden Schenkel des elektronischen Messgeräts ein Hall-Sensor angeordnet, mittels welchem der magnetische Fluss über die Querschnitte der beiden magnetischen Kerne gemessen wird. Das gemessene Signal wird in ein Spannungssignal oder ein Stromsignal umgewandelt und einer Messeinrichtung des elektrischen Messgeräts zugeführt.

Bei derartigen Messgeräten besteht die Herausforderung, dass eine nur geringe Genauigkeit bei Messungen von kleinen Strömen und geringen Frequenzen erreicht werden kann. Die die Magnetkerne umschließende Wand benötigt eine bestimmte Wandstärke, um eine ausreichende Stabilität und einen Schutz gemäß IP-Klassifikation für die Anwender zu gewährleisten. Der eingesetzte Hall-Sensor benötigt einen Spalt von mindestens 1,1 mm, der dazu führt, dass die Magnetkerne in der geschlossenen Position der Schenkel etwa 3 mm auseinanderliegen. Dies wiederum hat den Nachteil, dass ein kinetischer Flussverlust sich bei Spalten von mehr als 2,5 mm verstärkt. Dies führt einerseits zu einer verschlechterten Datenaufnahme und einer relativ großen Streuung. Der Querschnitt der eingesetzten Magnetkerne wäre zu vergrößern, um eine ausreichende Messgenauigkeit zu erhalten und die magnetischen Flussverluste zu kompensieren.

### Offenbarung der Erfindung

Erfindungsgemäß wird ein elektronisches Messgerät zur kontaktlosen Erfassung elektrischer Größen vorgeschlagen, insbesondere Strom und/oder Spannung, mit einem stationären Schenkel und einem bewegbaren Schenkel, in welchen jeweils Magnetkerne aufgenommen sind, wobei in einem der stationären oder bewegbaren Schenkel ein Hall-Sensor aufgenommen ist. In dem anderen Schenkel ist eine dem Hall-Sensor gegenüberliegende Wandstärkenreduzierung ausgebildet, welche die Abstände zwischen den Stirnseiten der Magnetkerne reduziert.

Durch die erfindungsgemäß vorgeschlagene Lösung kann erreicht werden, dass der Abstand zwischen den einander gegenüberliegenden Stirnseiten der beiden Magnetkerne reduziert wird, so dass die magnetischen Flussverluste signifikant abnehmen und gleichzeitig ein Schutz des Anwenders und des Gerätes gemäß IP-Klassifikation gewährleistet ist.

In vorteilhafter Weiterbildung der erfindungsgemäß vorgeschlagenen Lösung ist das elektronische Messgerät derart beschaffen, dass der die Wandstärkenreduzierung aufweisende stationäre oder bewegbare Schenkel ein frontseitiges und ein rückwärtiges Gehäuseteil aufweist.

Des Weiteren ist in vorteilhafter Weise beim erfindungsgemäß vorgeschlagenen elektronischen Messgerät vorgesehen, dass die Wandstärkenreduzierung als in den stationären oder in den bewegbaren Schenkel einsetzbares Einsatzteil ausgeführt ist.

Der erfindungsgemäß vorgeschlagenen Lösung weiter folgend ist das elektrische Messgerät derart beschaffen, dass das Einsatzteil quadratisch oder in Rechteckform ausgebildet ist.

In vorteilhafter Weise ist beim elektronischen Messgerät vorgesehen, dass das Einsatzteil einen übermoldeten Bereich aufweist, der ein wandstärkenreduziertes Fenster umschließt.

Das erfindungsgemäß vorgeschlagene elektronische Messgerät zeichnet sich ferner dadurch aus, dass das in die frontseitigen und rückwärtigen Gehäuseteile einsetzbare Einsatzteil, insbesondere dessen wandstärkenreduziertes Fenster, zu den Stirnseiten des ersten Magnetkerns oder zu den Stirnseiten des zweiten Magnetkerns fluchtet. Dadurch kann erreicht werden, dass der reduzierte Abstand zwischen den Stirnseiten der einander gegenüberliegenden Enden der Magnetkerne beziehungsweise der Abstand zwischen einem Hall-Sensor und der Stirnseite des diesem gegenüberliegenden Magnetkerns reduziert wird. Dadurch lässt sich eine erhebliche Reduzierung der magnetischen Flussverluste erreichen, wobei die Größe der Magnetkerne beibehalten werden kann.

In vorteilhafter Weise ist beim erfindungsgemäß vorgeschlagenen elektronischen Messgerät vorgesehen, dass die ersten und zweiten Magnetkerne jeweils eine im Wesentlichen halbkreisförmige Krümmung aufweisen.

Ferner zeichnet sich das erfindungsgemäß vorgeschlagene elektronische Messgerät dadurch aus, dass das Einsatzteil als flache Platte aus einem metallischen Material gefertigt ist und zumindest teilweise entlang seines Umfangs mit einer Anfasung versehen ist. Durch die Anfasung kann eine Vereinfachung der Montage des einsetzbaren Einsatzteils in eine Fassung in den miteinander zu fügenden frontseitigen und rückwärtigen Gehäuseteilen erreicht werden.

Des Weiteren ist beim erfindungsgemäß vorgeschlagenen elektrischen Messgerät vorgesehen, dass das Einsatzteil in einer Fassung in den frontseitigen und rückwärtigen Gehäuseteilen aufgenommen ist und diese Komponenten stoffschlüssig, insbesondere mittels Ultraschallschweißens miteinander gefügt werden.

Weiterhin ist beim erfindungsgemäß vorgeschlagenen elektronischen Messgerät vorgesehen, dass der stationäre und der bewegbare Schenkel eine geschlossene Position oder eine offene Position einnehmen und in der geschlossenen Position ein Auge begrenzen.

Darüber hinaus bezieht sich die Erfindung auf die Verwendung des elektronischen Messgeräts zur kontaktlosen Messung elektrischer Größen, insbesondere Strom und/oder Spannungen.

### Vorteile der Erfindung

Durch die erfindungsgemäß vorgeschlagene Lösung des Vorsehens einer Wandstärkenreduzierung an einander gegenüberliegenden Stirnseiten von Magnetkernen kann die Größe der Magnetkerne im Wesentlichen beibehalten werden und eine erhebliche Reduzierung der magnetischen Flussverluste erreicht werden. In vorteilhafter Weise kann durch die erfindungsgemäß vorgeschlagene Lösung der Abstand zwischen dem eingesetzten Hall-Sensor und der diesem gegenüberliegenden Stirnseite des Magnetkerns in die Größenordnung von 2 mm oder weniger reduziert werden. Durch die erfindungsgemäß vorgeschlagene Lösung kann in vorteilhafter Weise vermieden werden, sich ansonsten einstellende magnetische Flussverluste durch eine Vergrößerung der Magnetkerne ausgleichen zu müssen. Daher kann der in den Schenkeln des erfindungsgemäß vorgeschlagenen elektronischen Messgeräts vorhandene Bauraum beibehalten werden und auf ein handhabbares Maß reduziert werden. Insbesondere lässt sich auch das Gewicht des erfindungsgemäß vorgeschlagenen elektronischen Messgeräts beibehalten.

Wird das elektronische Messgerät während der Messung beispielsweise gedreht oder anderweitig bewegt, kann durch die erfindungsgemäß vorgeschlagene Lösung aufgrund des reduzierten Abstands im geschlossenen Zustand eine geringe Variation der übertragenen Daten beziehungsweise Signale erreicht werden, da die Magnetkerne sehr nahe einander gegenüberliegend angeordnet sind und die magnetischen Flussverluste äußerst gering sind.

Durch die erfindungsgemäß vorgeschlagene Wandstärkenreduzierung, insbesondere an der dem Hall-Sensor gegenüberliegenden Stirnseite des Magnetkerns kann diese vollständig mit Moldmaterial übermoldet werden. Anstelle des stoffschlüssigen Fügens der frontseitigen und rückwärtigen Gehäuseteile mittels Ultraschallschweißens können diese auch miteinander verklebt werden.

### Kurze Beschreibung der Zeichnungen

Ausführungsformen der Erfindung werden anhand der Zeichnungen und der nachfolgenden Beschreibung näher erläutert.

Es zeigen:
- Figur 1: eine perspektivische Ansicht eines elektronischen Messgeräts zur kontaktlosen Erfassung elektrischer Größen,
- Figur 2: eine Draufsicht auf die in geschlossener Position befindlichen stationären und bewegbaren Schenkel,
- Figur 3: die Darstellung einer offenen Position zwischen dem stationären und dem bewegbaren Schenkel,
- Figur 4: die Anordnung von im Wesentlichen halbkreisförmig beschaffenen Magnetkernen innerhalb der stationären und bewegbaren Schenkel,
- Figuren 5 und 5.1: Darstellungen des Einsatzteils zur Wandstärkenreduzierung,
- Figur 6: die Montage des Einsatzteils zwischen einem frontseitigen und einem rückwärtigen Gehäuseteil des bewegbaren Schenkels,
- Figur 7: die Anordnung des Einsatzteils in einer ersten Position und einer zweiten Position zwischen den miteinander zu fügenden frontseitigen und rückwärtigen Gehäuseteilen des bewegbaren Schenkels und
- Figur 8: eine Draufsicht auf die in der geschlossenen Position befindlichen stationären und bewegbaren Schenkel mit reduzierten Abständen im Bereich der Stirnseiten der Magnetkerne.

### Ausführungsformen der Erfindung

In der nachfolgenden Beschreibung der Ausführungsformen der Erfindung werden gleiche oder ähnliche Elemente mit gleichen Bezugszeichen bezeichnet, wobei auf eine wiederholte Beschreibung dieser Elemente in Einzelfällen verzichtet wird. Die Figuren stellen den Gegenstand der Erfindung nur schematisch dar.

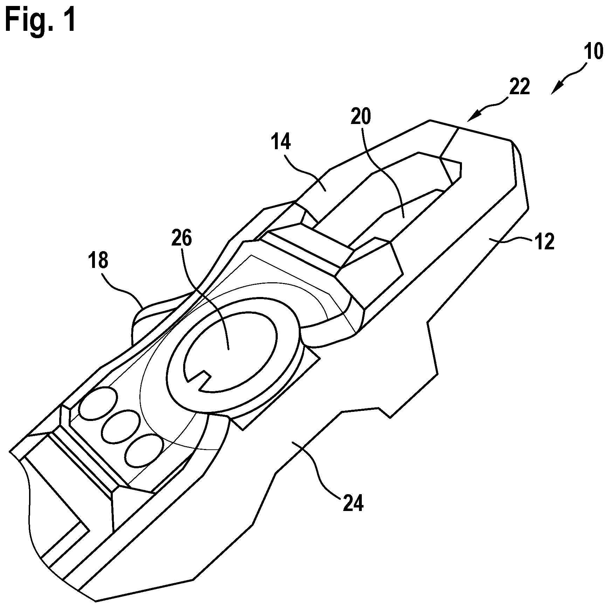

Der Darstellung gemäß Figur 1 ist ein elektronisches Messgerät 10 zur kontaktlosen Erfassung beziehungsweise Messung elektrischer Größen wie Strom und/ oder Spannung oder zur Erfassung des elektrischen Widerstands zu entnehmen. Das elektronische Messgerät 10 gemäß der perspektivischen Ansicht in Figur 1 umfasst einen stationären Schenkel 12 und einen diesem gegenüberliegenden bewegbaren Schenkel 14. In der Darstellung gemäß Figur 1 nehmen der stationäre Schenkel 12 und der bewegbare Schenkel 14 ihre geschlossene Position 22 an. Die beiden Schenkel 12, 14 können auch beispielsweise gleitend oder schlittenförmig relativ zueinander bewegbar ausgebildet sein. Das elektronische Messgerät 10 umfasst ein Gehäuse 24, in dem die Auswerteelektronik untergebracht ist. Mittels eines Wählschalters 26 können verschiedene Betriebsmodi des elektronischen Messgeräts 10 eingestellt werden, so beispielsweise die Messung von Wechselströmen oder Gleichströmen, die Messung von Wechsel- oder Gleichspannungen oder auch die Messung des elektrischen Widerstands. Mittels des hier als Drehknopf ausgebildeten Wahlschalters 26 können auch Größenordnungen von elektrischen Größen variiert werden, so dass das elektronische Messgerät 10 jeweils unterschiedliche Genauigkeiten annimmt, mit denen die jeweiligen elektrischen Größen zuverlässig gemessen werden können.

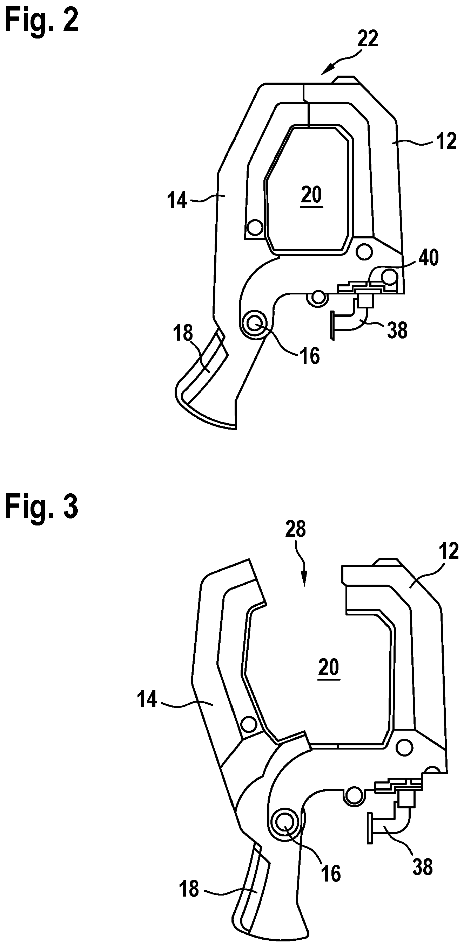

Der Darstellung gemäß Figur 2 ist zu entnehmen, dass sich der stationäre Schenkel 12 sowie der bewegbare Schenkel 14 in ihrer geschlossenen Position 22 befinden. In der geschlossenen Position 22 begrenzen der stationäre Schenkel 12 und der bewegbare Schenkel 14 ein Auge 20, durch welches beispielsweise der elektrische Leiter geführt ist, dessen Strom beziehungsweise dessen elektrische Spannung gemessen werden soll. In der Darstellung gemäß Figur 2 ist das Gehäuse 24, in welchem die Messelektronik aufgenommen ist, nicht dargestellt. Aus der Darstellung gemäß Figur 2 geht hervor, dass über einen elektrischen Anschluss 38 die Auswerteelektronik, die im Gehäuse 24 untergebracht ist, mit dem stationären 12 beziehungsweise dem bewegbaren Schenkel 14 des elektronischen Messgeräts 10 zur Datenübertragung verbunden ist. Figur 2 zeigt des Weiteren einen seitlich angeordneten Auslöser 18, mit dem eine Messung zur kontaktlosen Erfassung einer elektrischen Größe ausgelöst werden kann.

Figur 3 ist zu entnehmen, dass sich der stationäre Schenkel 12 und der bewegbare Schenkel 14 in einer offenen Position 28 befinden. Durch die Lücke, die in Figur 3 zwischen dem stationären Schenkel 12 und dem bewegbaren Schenkel 14 in deren offener Position 28 entsteht, kann das elektronische Messgerät 10 an einen auszumessenden Leiter beziehungsweise eine Leitung herangeführt werden. Sobald diese umschlossen ist, kann mittels des Faraday'schen Gesetzes eine kontaktlose Erfassung über den in dem umschlossenen, im Auge 20 befindlichen Leiter die Stromstärke erfasst werden.

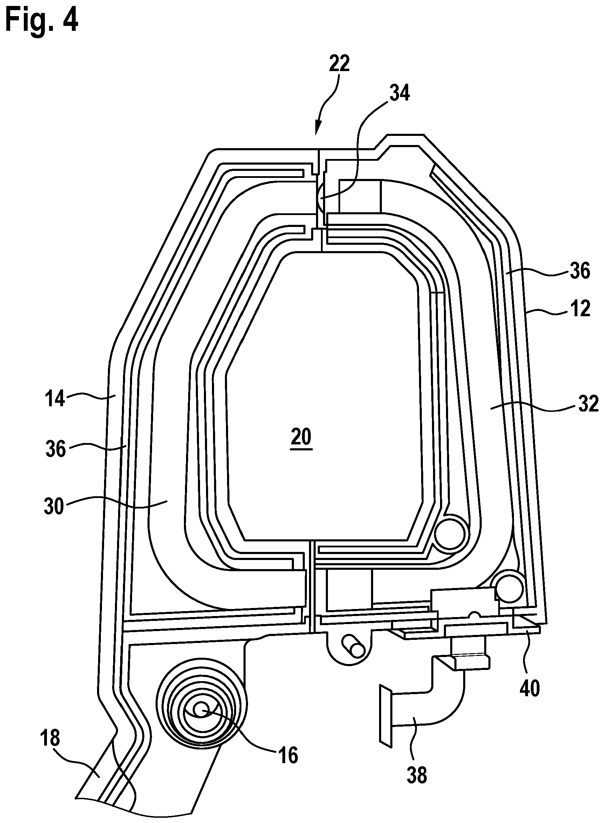

Figur 4 ist zu entnehmen, dass in den Gehäusen des stationären Schenkels 12 und des bewegbaren Schenkels 14, die aus einem nicht-leitenden Material, wie beispielsweise Kunststoff oder dergleichen gefertigt sind, im Wesentlichen eine halbkreisförmige Krümmung 74 aufweisende erste und zweite Magnetkerne 30, 32 aufgenommen sind. Die Magnetkerne 30, 32 liegen in der geschlossenen Position 22 mit ihren Stirnseiten, wie noch genauer beschrieben werden wird, einander gegenüber. An einem der beiden Schenkel, entweder am stationären Schenkel 12 oder am bewegbaren Schenkel 14 ist ein Hall-Sensor 34 untergebracht.

Mittels eines Dichtelements 40 ist der Anschluss 38 zur Auswerteelektronik in dem in Figur 4 nicht dargestellten Gehäuse des elektronischen Messgeräts 10 abgedichtet. In der Darstellung gemäß Figur 4, welche einen Schnitt durch die in geschlossener Position 22 befindlichen stationären und bewegbaren Schenkel 12, 14 darstellt, sind lediglich die rückwärtigen Gehäuseteile 56, in welche die eine halbkreisförmige Krümmung 74 aufweisenden ersten und zweiten Magnetkerne 30, 32 eingelegt sind, gezeigt.

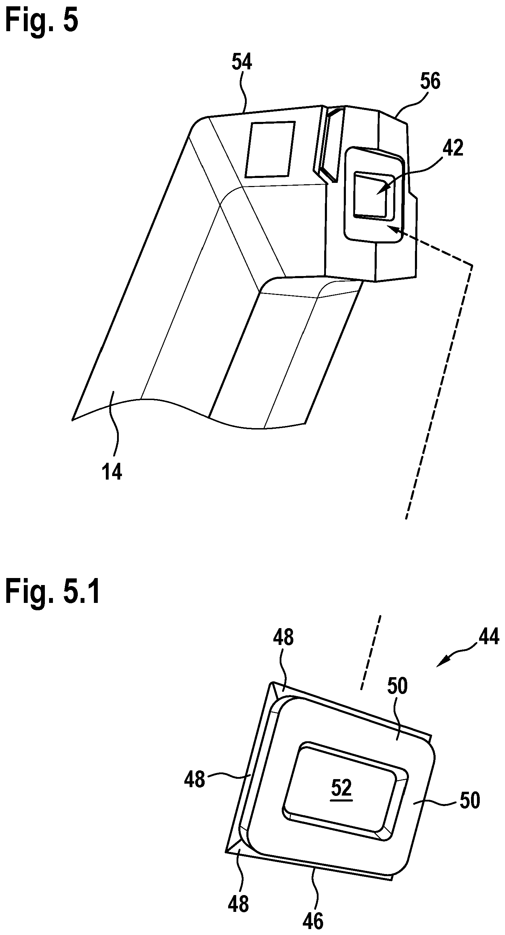

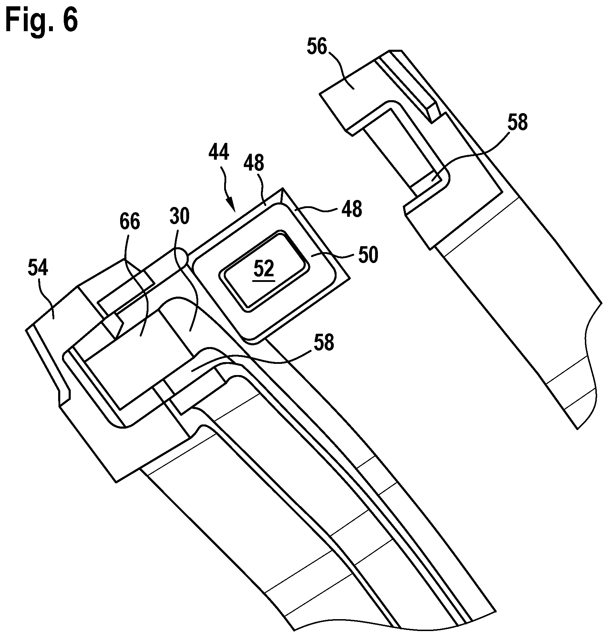

Der Darstellung gemäß den Figuren 5 und 5.1 ist die Ausführung einer Wandstärkenreduzierung 42 am oberen Ende, hier des bewegbaren Schenkels 14 des elektronischen Messgeräts 10, zu entnehmen. Figur 5.1 zeigt, dass das Einsatzteil 44 im Wesentlichen als ebenes Bauelement ausgebildet ist und beispielsweise als Platte aus einem metallischen Material ausgeführt sein kann. In der in Figur 5.1 dargestellten Ausführungsvariante ist das Einsatzteil 44 in Rechteckform 46 beschaffen, kann jedoch auch eine quadratische oder eine andere Geometrie aufweisen. Entlang seines gesamten Umfangs oder entlang von Teilen des Umfangs kann das Einsatzteil 44 eine Anfasung 48 aufweisen. Ein wandstärkenreduziertes Fenster 52 des Einsatzteils 44 ist von einem umlaufenden, übermoldeten Bereich 50 begrenzt. Figur 5.1 zeigt das Einsatzteil 44 im in die miteinander gefügten frontseitigen und rückwärtigen Gehäuseteile 54, 55 montierten Zustand. Durch das wandstärkenreduzierte Fenster 52, welches vom übermoldeten Bereich 50 umschlossen wird, wird die Wandstärkenreduzierung 42 am oberen Ende des hier dargestellten bewegbaren Schenkels 14 gebildet. Figur 6 ist zu entnehmen, dass vor dem Fügen des frontseitigen Gehäuseteils 54 und des rückwärtigen Gehäuseteils 56 das Einsatzteil 44 entsprechend in eine Fassung 58 eingeführt wird, welche sowohl mit einem Teil im frontseitigen Gehäuseteil 54 als auch mit einem weiteren Teil im rückwärtigen Gehäuseteil 56 ausgebildet ist. Im gefügten Zustand fluchtet das wandstärkenreduzierte Fenster 52, welches vom übermoldeten Bereich 50 umschlossen ist, mit der hier dargestellten ersten Stirnseite 66 des ersten Magnetkerns 30, der in dem frontseitigen Gehäuseteil 54 und dem rückwärtigen Gehäuseteil 56 aufgenommen ist.

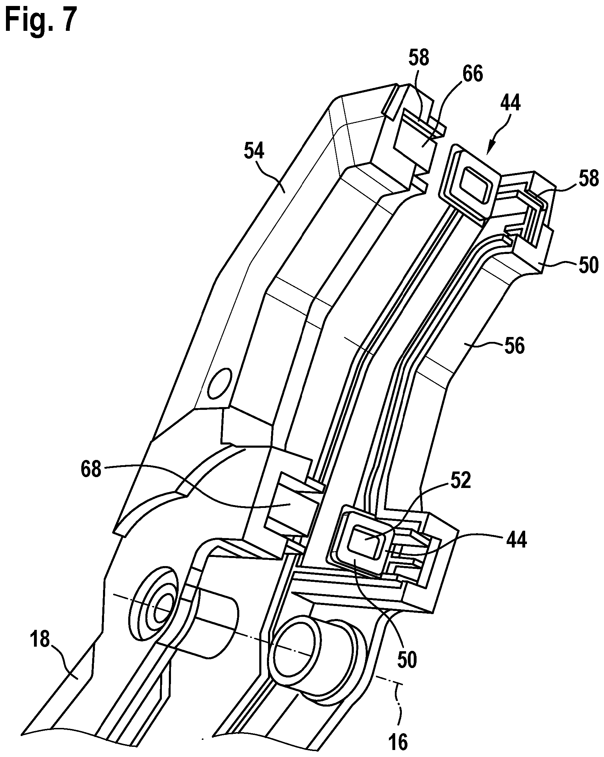

Der Darstellung gemäß Figur 7 ist zu entnehmen, dass das als ebenes Bauteil aus metallischem Material ausgebildete Einsatzteil 44 in einer ersten Position 60 sowie auch in einer zweiten Position 62 zwischen den miteinander zu fügenden frontseitigen und rückwärtigen Gehäuseteilen 54, 56 eingebaut wird. Auch aus der Darstellung gemäß Figur 7 geht hervor, dass im montierten Zustand das wandstärkenreduzierte Fenster 52 des Einsatzteils 44 mit den jeweiligen ersten und zweiten Stirnseiten 66, 68 des ersten Magnetkerns 30 fluchtet.

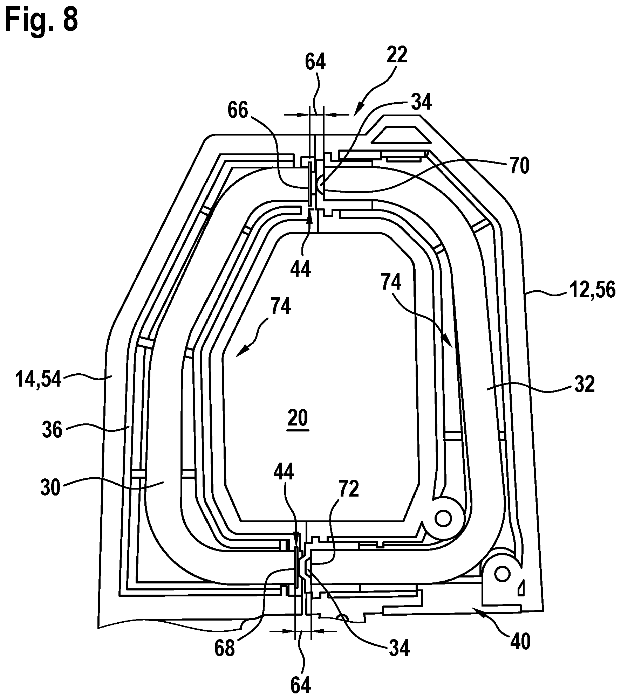

Der Draufsicht gemäß Figur 8 ist zu entnehmen, dass den ersten und zweiten Stirnseiten 66, 68 des ersten Magnetkerns 30 besagtes, als ebenes Bauteil ausgebildete Einsatzteil 44 zugeordnet ist. Durch die Anordnung des als ebenes Bauteil ausgebildeten Einsatzteils 44 mit wandstärkenreduziertem Fenster 52 unmittelbar vor den ersten und zweiten Stirnseiten 66, 68 des ersten Magnetkerns 30 lässt sich ein minimaler Abstand 64 zwischen den ersten und zweiten Stirnseiten 66, 68 des ersten Magnetkerns 30 einerseits und dem Hall-Sensor 34 andererseits, der vor den ersten beziehungsweise zweiten Stirnseiten 70, 72 des zweiten Magnetkerns 32 angeordnet ist, erzielen. Die im Wesentlichen eine halbkreisförmige Krümmung 74 aufweisenden Magnetkerne 30, 32 sind in die hier in der Draufsicht dargestellten rückwärtigen Gehäuseteile 56 eingelassen. Die Hall-Sensoren 34 können an besagten ersten und zweiten Positionen 60, 62, wie in Figur 7 angedeutet, angeordnet werden, so dass diese exakt den wandstärkenreduzierten Fenstern 52 des Einsatzteils 44 gegenüberliegend angeordnet sind. Durch die Wandstärkenreduzierung 42 wird eine erhebliche Reduzierung der magnetischen Flussverluste erreicht, so dass unter Beibehaltung gleicher Größen hinsichtlich der Magnetkerne 30, 32 eine deutlich genauere Messung bei erheblich verbessertem magnetischem Fluss erreicht werden kann. Eine Kompensation magnetischer Flussverluste durch eine Vergrößerung der Dimension der Magnetkerne 30, 32 kann durch die erfindungsgemäß vorgeschlagene Lösung vermieden werden.

Figur 8 ist zu entnehmen, dass das Einsatzteil 44 mit dem wandstärkenreduzierten Fenster 52 jeweils den ersten und zweiten Stirnseiten 66, 68 des ersten Magnetkerns 30 zugeordnet ist. Alternativ besteht die Möglichkeit, das Einsatzteil 44 auch vor dem Hall-Sensor 34 anzubringen, so dass der reduzierte Abstand 64 zwischen den beiden Magnetkernen 30, 32 nochmals um die Wandstärke des rückwärtigen Gehäuseteils 56 reduziert werden kann. Anstelle des Fügens mittels Ultraschallschweißens können das frontseitige Gehäuseteil 54 und das rückwärtige Gehäuseteil 56 des stationären und des bewegbaren Schenkels 12, 14 auch miteinander verklebt oder anderweitig stoffschlüssig gefügt werden.

Des Weiteren bezieht sich die Erfindung auf die Verwendung des elektronischen Messgeräts 10 zur kontaktlosen Messung elektrischer Größen, insbesondere Strom und/oder Spannungen.

Die Erfindung ist nicht auf die hier beschriebenen Ausführungsbeispiele und die darin hervorgehobenen Aspekte beschränkt. Vielmehr ist innerhalb des durch die Ansprüche angegebenen Bereichs eine Vielzahl von Abwandlungen möglich, die im Rahmen fachmännischen Handelns liegen.

## Patentansprüche

1. Elektronisches Messgerät (10) zur kontaktlosen Erfassung elektrischer Größen, insbesondere Strom und/oder Spannung, mit einem stationären Schenkel (12) und einem bewegbaren Schenkel (14), in welchen jeweils Magnetkerne (30, 32) aufgenommen sind, wobei in einem der stationären oder bewegbaren Schenkel (12, 14) ein Hall-Sensor (34) aufgenommen ist, **dadurch gekennzeichnet, dass** in dem jeweils anderen Schenkel (12, 14) eine dem Hall-Sensor (34) gegenüberliegende Wandstärkenreduzierung (42) ausgebildet ist, die Abstände (64) zwischen Stirnseiten (66, 68; 70, 72) der Magnetkerne (30, 32) reduziert.

2. Elektronisches Messgerät (10) gemäß Anspruch 1, **dadurch gekennzeichnet, dass** der die Wandstärkenreduzierung (42) aufweisende stationäre oder bewegbare Schenkel (12, 14) ein frontseitiges und ein rückwärtiges Gehäuseteil (54, 56) aufweist.

3. Elektronisches Messgerät (10) gemäß den Ansprüchen 1 bis 2, **dadurch gekennzeichnet, dass** die Wandstärkenreduzierung (42) als in den stationären oder bewegbaren Schenkel (12, 14) einsetzbares Einsatzteil (44) ausgeführt ist.

4. Elektronisches Messgerät (10) gemäß den Ansprüchen 1 bis 3, **dadurch gekennzeichnet, dass** das Einsatzteil (44) quadratisch oder in Rechteckform (46) ausgeführt ist.

5. Elektronisches Messgerät (10) gemäß den Ansprüchen 1 bis 4, **dadurch gekennzeichnet, dass** das Einsatzteil (44) einen übermoldeten Bereich (50) aufweist, der ein wandstärkenreduziertes Fenster (52) umschließt.

6. Elektronisches Messgerät (10) gemäß den Ansprüchen 1 bis 5, **dadurch gekennzeichnet, dass** das in die frontseitigen und rückwärtigen Gehäuseteile (54, 56) einsetzbare Einsatzteil (44), insbesondere dessen wandstärkenreduziertes Fenster (52), zu den Stirnseiten (66, 68) des ersten Magnetkerns (30) oder zu den Stirnseiten (70, 72) des zweiten Magnetkerns (32) fluchtet.

7. Elektronisches Messgerät (10) gemäß den Ansprüchen 1 bis 6, **dadurch gekennzeichnet, dass** die ersten und zweiten Magnetkerne (30, 32) jeweils eine im Wesentlichen halbkreisförmige Krümmung (74) aufweisen.

8. Elektronisches Messgerät (10) gemäß den Ansprüchen 1 bis 7, **dadurch gekennzeichnet, dass** das Einsatzteil (44) als flache Platte aus einem metallischen Material ausgeführt ist und zumindest teilweise entlang seines Umfangs mit einer Anfasung (48) versehen ist.

9. Elektronisches Messgerät (10) gemäß den Ansprüchen 1 bis 8, **dadurch gekennzeichnet, dass** das Einsatzteil (44) in einer Fassung (58) in den frontseitigen und rückwärtigen Gehäuseteilen (54, 56) aufgenommen ist und diese Komponenten stoffschlüssig, insbesondere durch UltraschallSchweißen, miteinander gefügt sind.

10. Elektronisches Messgerät (10) gemäß den Ansprüchen 1 bis 9, **dadurch gekennzeichnet, dass** der stationäre und der bewegbare Schenkel (12, 14) eine geschlossene Position (22) oder eine offene Position (28) einnehmen und in der geschlossenen Position (22) ein Auge (20) begrenzen.

11. Verwendung des elektronischen Messgeräts (10) gemäß einem der Ansprüche 1 bis 10 zur kontaktlosen Messung elektrischer Größen, insbesondere Strom und/oder Spannung.
